# EUROPÄISCHE PATENTSCHRIFT

(11) **EP 3 097 642 B1**
(45) Veröffentlichungstag und Bekanntmachung des Hinweises auf die Patenterteilung: **27.09.2023**
(21) Anmeldenummer: 14827745.2
(22) Anmeldetag: 19.12.2014
(51) Int. Cl.: H03K 17/955, H03K 17/945

(54) **BETÄTIGUNGSEINRICHTUNG FÜR EIN KRAFTFAHRZEUG**
ACTIVATION DEVICE FOR A MOTOR VEHICLE
DISPOSITIF ACTIONNEUR POUR VÉHICULE À MOTEUR

(30) Priorität: 22.01.2014 DE 102014100698
(43) Veröffentlichungstag der Anmeldung: 30.11.2016
(73) Patentinhaber: Huf Hülsbeck & Fürst GmbH & Co. KG, 42551 Velbert (DE)
(72) Erfinder: BUSCHMANN, Gerd, 42553 Velbert (DE); VAN GASTEL, Peter, 42699 Solingen (DE); KLAMETH, Markus, 71155 Altdorf (DE); METZNER, Thomas, 75365 Calw (DE)
(74) Vertreter: Zenz Patentanwälte Partnerschaft mbB
(86) Internationale Anmeldenummer: PCT/EP2014/078667
(87) Internationale Veröffentlichungsnummer: WO 2015/110239

(56) Entgegenhaltungen:
- WO-A1-2009/153161
- WO-A1-2011/063377
- DE-A1-102006 003 174
- DE-A1-102009 001 412
- DE-A1-102009 007 707
- DE-A1-102010 010 574
- DE-A1-102011 088 653
- DE-U1-202005 013 420
- DE-U1-202005 013 420
- FR-A1- 2 933 825
- US-A1- 2011 043 227
- US-A1- 2011 298 699
- US-A1- 2013 062 182
- US-B1- 6 774 505
- US-B2- 8 552 746

## Beschreibung

Die Erfindung betrifft eine Betätigungseinrichtung zur Verwendung an einem Kraftfahrzeug. Insbesondere betrifft die Erfindung eine Baugruppe, die am Kraftfahrzeug angeordnet wird, um eine Betätigung einer Fahrzeugfunktion zu ermöglichen.

Im Stand der Technik sind zahlreiche Baugruppen für Fahrzeuge bekannt, die unterschiedlichsten Funktionen dienen.

Aus dem Dokument WO 2011/063377 A1 ist eine Bedieneinheit mit einem Berührungssensor mit einer oder mehreren Sensorelektroden und Schaltungsträgersubstrat bekannt. Das Schaltungsträgersubstrat enthält eine Berührungsoberfläche, die ein leitfähiges Material umfasst. Ein Spalt trennt einen Teil des leitfähigen Materials, der über einer der Sensorelektroden liegt, von umgebenden Teilen des leitfähigen Materials.Eine Baugruppe ist beispielsweise aus der EP 2 067 665 A1 bekannt. Dort wird ein Herstelleremblem oder Herstellerlogo an einem Fahrzeug angebracht und mit Hilfe einer Lichtquelle und einer Lichtleiteinrichtung hinterleuchtet.

Ein weiteres hinterleuchtetes Fahrzeuglogo ist aus der DE 10 2004 024 263 A1 bekannt.

Die genannten beleuchteten Fahrzeugembleme dienen dabei ausschließlich der Verbesserung des Designs und der verbesserten Wertanmutung eines Fahrzeuges. Einen weitergehenden funktionalen Nutzen erfüllen sie jedoch nicht.

Der Erfindung liegt die Aufgabe zugrunde, eine integrierbare multifunktionale Baugruppe für Fahrzeuge zur Verfügung zu stellen.

Diese Aufgabe wird erfindungsgemäß gelöst durch eine Betätigungseinrichtung mit den Merkmalen des Patentanspruchs 1.

Gemäß der Erfindung wird ein gestaltetes Zierelement, insbesondere ein Fahrzeugemblem (oder auch Herstelleremblem) mit einer Annäherungs-Sensorik kombiniert, um eine Baugruppe zur Betätigung einer Fahrzeugfunktion zur Verfügung zu stellen.

Dafür weist die erfindungsgemäße Baugruppe ein dem Benutzer zugewandtes oberes Deckelement auf, welches teilweise als Fahrzeugemblem ausgebildet ist. Wenn hierbei von Fahrzeugemblem die Rede ist, ist jedes beliebige Zier- oder Markenelement gemeint, welches eine optische Aufwertung oder Kennzeichnung des Fahrzeuges vornehmen soll. Das Deckelement ist wenigstens teilweise aus einem metallischen Material gebildet oder mit einem metallischen Überzug versehen.

Unter diesem Deckelement ist erfindungsgemäß eine Lichtverteileinrichtung angeordnet. Unter der Lichtverteileinrichtung oder darin ist wiederum eine Lichtquelle angeordnet, so dass durch Lichtquelle und Lichtverteileinrichtung in ihrer kombinierten Wirkung eine Hinterleuchtung des darauf angeordneten Deckelementes erfolgt.

Schematisch ist der Aufbau bis zu diesem Punkt vergleichbar mit dem vorstehend genannten Stand der Technik, insbesondere der EP 2 067 665 A1. Dort wird als erfindungsgemäße Lichtverteileinrichtung eine Lichtleiteinrichtung mit Lichtleitflächen oder Lichtumlenkflächen verwendet. Ebenso gut kann aber eine andere Art von Lichtverteileinrichtung, beispielsweise eine mehradrige Lichtleitereinrichtung oder auch ein Diffusor Verwendung finden.

Erfindungsgemäß erschöpft sich die Funktion der Baugruppe jedoch nicht in der Hinterleuchtung eines Zierelements, sondern dient der Sensierung von Funktionsbetätigungen.

Dazu ist das Deckelement galvanisch von den übrigen leitenden Elementen der Umgebung der Betätigungseinrichtung getrennt. Insbesondere ist eine galvanische Entkopplung des Deckelements von der Fahrzeugmasse vorgesehen. Diese Entkopplung kann durch Isolationselemente zwischen Deckelement und weiteren Komponenten erfolgen, die Isolation kann jedoch insbesondere auch durch die unter dem Deckelement angeordnete Lichtleiteinrichtung oder Lichtverteileinrichtung realisiert werden. Die Lichtleiteinrichtung oder Lichtverteileinrichtung ist dazu aus einem elektrisch isolierenden Material, z.B. einem transparenten Kunststoff oder Glas gebildet.

Unter der Lichtverteileinrichtung ist eine Platine mit einem kapazitiven Kopplungselement, z.B. einem kapazitiven Sensor angeordnet. Der kapazitive Sensor ist wenigstens durch die Lichtleiteinrichtung oder Lichtverteileinrichtung von dem metallischen Deckelement beabstandet, also galvanisch von diesem getrennt, aber kapazitiv mit diesem gekoppelt. Änderungen der Kapazität des Deckelementes wirken sich entsprechend unmittelbar auf das kapazitive Sensorelement aus. Dabei ist der eigentliche Sensor jedoch geschützt und gegen Umwelteinflüsse weitgehend geschirmt aufgenommen, nur das Deckelement liegt frei und kann von einem Bediener durch Annäherung eines Körperteils oder durch Berührung in seiner Kapazität beeinflusst werden.

Der Annäherungssensor sensiert durch die Lichtverteileinrichtung eine Kapazitätsänderung durch Annäherung eines Benutzers an das Deckelement. Da der Sensor auf der dem Benutzer abgewandten Seite des Deckelementes liegt, sieht der Benutzer das beleuchtete Deckelement ohne störende Sensorelemente und kann die sensierte Fläche problemlos auffinden.

Es befinden sich nämlich Herstellerembleme oder Fahrzeugembleme an prominenten Stellen am Fahrzeug, so dass ein Auffinden dieser Embleme unproblematisch ist. Dies ist ein Vorteil der Erfindung, da das Betätigungselement gleichzeitig als Designelement wirkt und prominenten, bequem zugänglichen Stellen am Fahrzeug anzuordnen ist. Im Stand der Technik werden hingegen Bedienelemente oft dezent aber an problematisch zugänglichen Stellen angeordnet, da sie das Erscheinungsbild eines Fahrzeuges schmälern können. Außerdem schützt bei der Erfindung das Deckelement mit der Lichtverteileinrichtung den eigentlichen kapazitiven Sensor vor Umwelteinflüssen.

Mit sowohl der Lichtquelle als auch dem kapazitiven Sensor, nicht jedoch mit dem Deckelement, ist eine Steuer- und Auswerteschaltung gekoppelt, die unmittelbar auf der Platine angeordnet sein kann, ebenso jedoch auch an einer anderen Position der Baugruppe platziert sein kann. Diese Steuer- und Auswerteschaltung steuert den kapazitiven Sensor in der technisch vorgesehenen Weise an. Als Sensoren kommen kapazitive Annäherungssensoren in Frage. Diese sind im Markt verfügbar und mit entsprechenden Schaltvorschriften versehen. Kapazitive Sensoren können durch Metallflächen gebildet werden, die mit einer geeigneten Ladeelektronik gekoppelt sind. Der Erfassungsbereich des Sensors erstreckt sich durch die davor, zum Benutzer hin ausgerichteten Komponenten und sensiert kontaktlos die Annäherung eines Benutzers. In der erfindungsgemäßen Vorrichtung wirkt das Deckelement wie eine zusätzliche Koppelelektrode des kapazitiven Sensors. Dazu bedarf es keiner galvanischen Kopplung, die zueinander beabstandete, fixierte Anordnung von Deckelement und darunter liegendem Sensor ermöglichen die Kopplung einer statischen Grundkapazität des Deckelements mit dem Sensor. Bei Annäherung eines Bedieners an das Deckelement wird diese Grundkapazität verändert und der Sensor detektiert diese Kapazitätsänderung.

In Abhängigkeit von der Sensierung der Annäherung und Steuersignalen des Fahrzeuges ist es der Steuer- und Auswerteeinrichtung möglich, die Lichtquelle in der Betätigungseinrichtung anzusteuern. Diese Ansteuerung kann in vielfältiger Weise erfolgen. Beispielsweise kann das Licht genutzt werden, um den Benutzer für eine Benutzung anzuleiten. Die Farbe der Lichtquelle kann außerdem geändert werden, um einen Betriebszustand der Einrichtung anzuzeigen. Beispielsweise kann das Fahrzeugemblem in einer ersten Farbe hinterleuchtet werden, wenn sich das Fahrzeug oder eine Klappe, welche mittels der Betätigungseinrichtung zu öffnen ist, in verriegeltem Zustand befindet. Die Farbe kann dann in Abhängigkeit von Verriegelungszustand geändert werden. Außerdem kann die Beleuchtungseinrichtung angesteuert werden, um die Annäherung des Benutzers oder Betätigung zu quittieren. Schließlich kann auch die Beleuchtungseinrichtung verwendet werden, um den Benutzer Hinweise für eine korrekte Bedienung zu geben. Nähert sich beispielsweise der Benutzer der Betätigungseinrichtung an, berührt diese ggf. sogar, so kann dies als erster Abschnitt eines Betätigungsschemas betrachtet werden. Die Steuer- und Auswerteeinrichtung erfasst diese Annäherung und das Verharren des Benutzers in der angenäherten Position. Der Benutzer lässt beispielsweise die Hand in einigen Zentimeter Entfernung vor der Betätigungseinrichtung verharren oder legt sie für einige Sekunden auf das Deckelement auf. Dies wird aufgrund der kapazitiven Kopplung des Deckelements mit dem kapazitiven Sensor detektiert.

Möchte nun der Benutzer die Fahrzeugfunktion aufrufen, so wird er durch ein Lichtsignal, hervorgerufen von der Steuer- und Auswerteeinrichtung aufgefordert, die Hand in einem bestimmten Zeitfenster wieder zu entfernen oder eine sonstige Geste, beispielsweise ein Abheben und erneutes Auflegen, auszuführen. Folgt der Benutzer dieser Vorgabe, so wird die Fahrzeugfunktion ausgelöst.

Die erfindungsgemäße Baugruppe bietet demnach eine neuartige Kombination von optischer Kennzeichnung und Betätigung. Die Baugruppe ist nach ästhetischen Vorgaben verwendbar, erfüllt jedoch insbesondere den technischen Zweck in Kombination mit dem darin angeordneten Annäherungssensor. Der Annäherungssensor mit gekoppeltem Deckelement wiederum, kombiniert mit der Leuchtfunktion, ermöglicht einen besonders verlässlichen und benutzerfreundlichen Zugriff. Da er sich in einem Bereich des Fahrzeuges befindet, wo ein Fahrzeugemblem regelmäßig zur Kenntlichmachung zu positionieren ist, ist diese Einrichtung auch vorteilhaft zugänglich am Fahrzeug anzuordnen. Die ästhetische Wirkung ist also Schlüssel oder Rechtfertigung für eine besonders günstige Anordnung am Fahrzeug und erschließt ganz neue Bedienmöglichkeiten.

In einer bevorzugten Ausgestaltung der Erfindung weist das Deckelement eine teilweise lichtdurchlässige Frontseite auf und die Lichtverteilungseinrichtung ist zum Ausleuchten der lichtdurchlässigen Bereiche des Deckelementes ausgebildet.

Grundsätzlich kann das Deckelement vollständig opak, also lichtundurchlässig und z.B. ganzflächig metallisiert ausgebildet sein. Die Lichtverteileinrichtung hinterleuchtet das Deckelement dann in einer solchen Weise, dass entlang des Umfangs des Deckelementes Licht austritt, so dass sich diese Konturlinie von der Umgebung abhebt. Das Deckelement kann jedoch besonders bevorzugt lichtdurchlässige Bereiche aufweisen, um eine noch bessere visuelle Wahrnehmung des Deckelementes und der Baugruppe mit ihrer Betätigungsfunktion zu erlauben. In dieser Weiterbildung der Erfindung sind entsprechend Teilbereiche des Deckelements metallisiert, beispielsweise verchromt oder mit einem Metallüberzug versehen. Das Deckelement kann beispielsweise aus transparenten oder opaken Kunststoffkörpern geformt sein, die teilweise mit einem Chromüberzug versehen sind. Das Deckelement kann auch mehrteilig ausgebildet sein. Beispielsweise ist es möglich, das Deckelement mit einem verchromten Emblem zu versehen, welches auf einem transparenten oder teiltransparenten Träger angeordnet ist. Das Deckelement wird dann durch die Kombination des Trägers mit dem aufgebrachten Emblem gebildet.

Die Lichtverteileinrichtung ist in vielfältiger Weise zu gestalten, beispielsweise durch eine einfache Kunststoffscheibe, in welche Licht aus einer Lichtquelle (beispielsweise LED) eingeleitet wird.

Die Lichtverteilung kann auch in einer Art geschehen, dass Licht an diskreten Positionen zur Durchleuchtung der Deckeinrichtung geleitet wird, beispielsweise durch einzelne oder Bündel von Lichtleitfasern. Außerdem können flächige Lichtleiteinrichtungen in Gestalt von Diffusoren oder Lichtleitscheiben mit geometrischer Ausgestaltung gebildet werden, bei denen Licht entlang von Linien oder Flächen austritt.

Die Erfindung wird nun anhand der beiliegenden Zeichnungen näher erläutert.
Figur 1a zeigt eine erste Ausführungsform der Erfindung in einer perspektivischen Schrägansicht von vorne.
Figur 1b zeigt die Ausführungsform aus Figur 1a in einer perspektivischen Schrägansicht von hinten.
Figur 2a zeigt eine erste Explosionsdarstellung der ersten Ausführungsform.
Figur 2b zeigt eine zweite Explosionsdarstellung der ersten Ausführungsform.

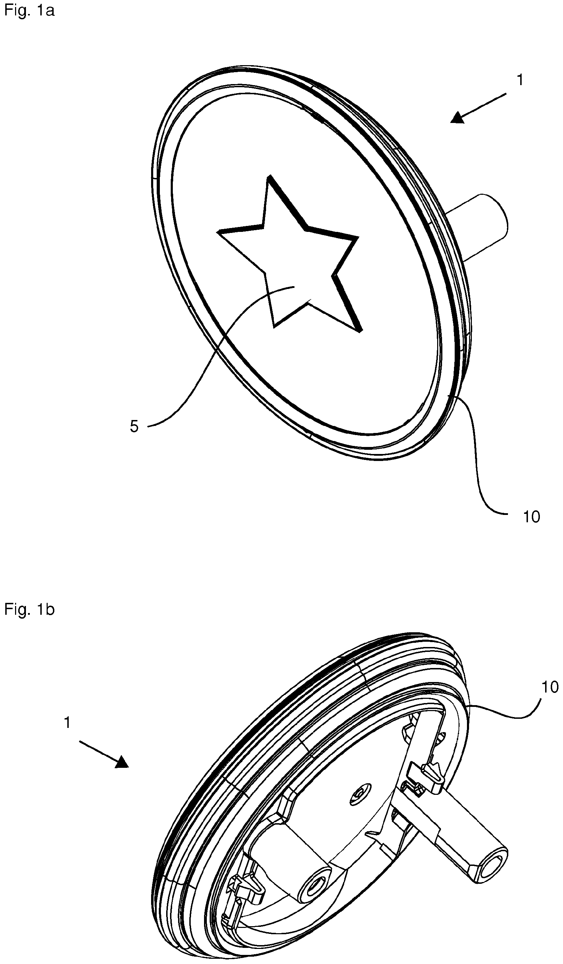

Die Figuren 1a und 1b zeigen die erfindungsgemäße Bedieneinrichtung 1 in montierter Gestaltung. Die so dargestellte Baugruppe kann in einer Ausnehmung am Fahrzeugblech, z. B. an der Heckklappe eines Fahrzeuges, montiert werden. In dieser Ausführungsform ist das Fahrzeugemblem 5 in stilisierter Weise dargestellt.

Ein tellerförmiges Gehäuse 10 umschließt die verschiedenen Komponenten der erfindungsgemäßen Baugruppe und bietet auf der Rückseite Montagemöglichkeiten, insbesondere Clips und Öffnungen für Zuleitungen, für Signalleitungen und Versorgungsleitungen, für die Steuer- und Auswerteschaltung sowie die Annäherungssensoren und die Lichtquelle.

Die dargestellte erfindungsgemäße Baugruppe ist kompakt und umfasst die Funktionen der Annäherungserkennung, der Leuchtwirkung für das Fahrzeugemblem und einen Tastschalter.

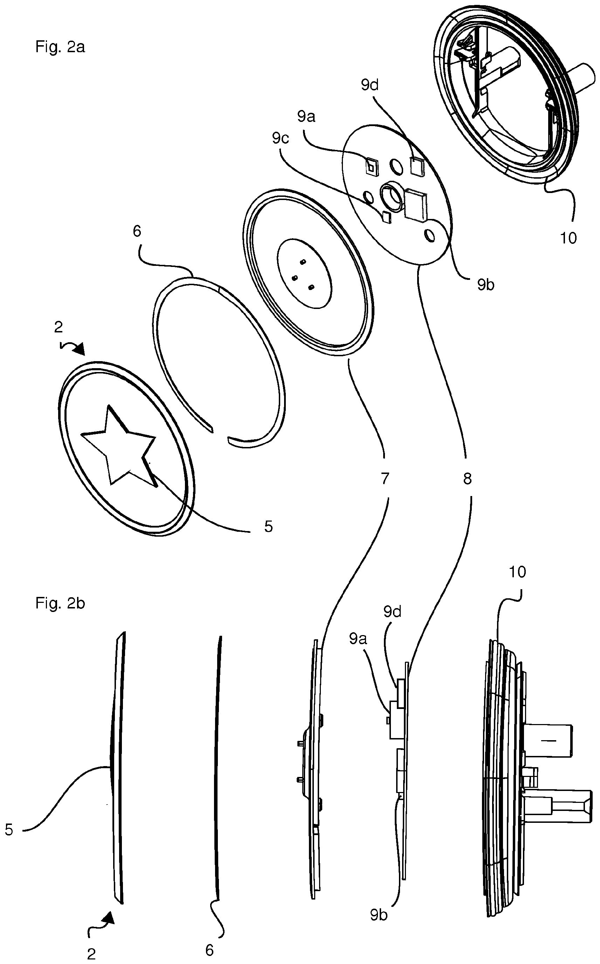

Die Figuren 2a und 2b zeigen in jeweiligen Explosionsdarstellungen den Aufbau der erfindungsgemäßen Einrichtung.

Dem Benutzer zugewandt, ist ein Deckelement 2, welches in diesem Beispiel einen runden transparenten Deckel aufweist, der im Zentrum ein chrombelegtes Sternemblem 5 aufweist. In anderen Gestaltungen können abweichende, plastisch geformte Herstellerembleme verwendet werden, zur Verdeutlichung der Erfindung genügt jedoch ein einfaches Element. Das Deckelement 2 wird mit einem ringförmigen, zu beiden Seiten mit Klebstoff versehenen Klebeelement 6 auf dem Lichtleiterelement fixiert. Das Lichtleiterelement 7 weist eine ähnliche Gestaltung auf, wie das Deckelement 2 selbst, ist jedoch aus einem Lichtleitermaterial mit entsprechenden Ausformungen versehen, um eine Hinterleuchtung des zentralen Elementes 5 zu gewährleisten. Dazu weist das Lichtleiterelement 7 im zentralen Bereich eine erhabene Lichtaustrittsfläche auf, die in ihrer Kontur hinter dem Fahrzeugemblem 5 liegt. In diesem Bereich sind zusätzlich Lichtaustrittspunkte definiert, die für eine zusätzliche Hinterleuchtung des Chromelementes 5 sorgen.

Hinter dem Lichtleitelement 7 ist eine Platine 8 angeordnet. Diese Platine wird von der Gehäusestruktur 10 getragen, wie bereits oben unter Verweis auf die Figuren 1a und 1b gezeigt wurde. Das Gehäuse 10 dient zur Festlegung am Fahrzeug und zur sicheren Aufnahme der Platine. Außerdem stützt die Gehäusestruktur sich am Fahrzeug ab und das Deckelement 2, welches auf das Lichtleiterelement 7 verklebt ist, kann gegen die Gehäusestruktur und damit gegen die Platine 8 entgegen einer Federvorspannung bewegt werden. Die Federelemente sind in dieser Gestaltung aus Gründen der Übersichtlichkeit nicht dargestellt.

Auf der Platine 8 ist sowohl ein kapazitiver Sensor 9b angeordnet, als auch eine oberflächenmontierte LED 9c, welche die Ausleuchtung des Lichtlenkelementes 7 übernimmt. Des Weiteren ist ein Mikroschalter 9a auf der Platine angeordnet, der eine Druckbetätigung registriert, wenn sich die Bauteile der Deckplatte 2 mit dem Lichtleiter 7 gegen die Platine 8 bewegen und den Druckschalter 9a in Gestalt eines Mikroschalters auslösen.

Das metallisierte Element 5 ist ersichtlich galvanisch durch den nicht-metallisierten Bereich des Deckelementes 2, die Klebeschicht 6 und den Lichtleiter 7 von der Platine getrennt. Auch von der Fahrzeugmasse ist das Emblem 5 getrennt. Dennoch stellt die Metallfläche des Emblems 5 eine kapazitiv mit dem Sensor 9b gekoppelte Kondensatorfläche dar. Auf diese Weise fokussiert das Emblem den Erfassungsbereich des Sensors 9b und lässt den Sensor empfindlich auf Annäherungen an das Element 5 reagieren.

Eine Steuer- und Auswerteeinrichtung 9d ist mit den Komponenten 9a, 9b und 9c gekoppelt.

Das dargestellte Ausführungsbeispiel stellt also eine Betätigungseinrichtung zur Verfügung, welche ein Fahrzeugemblem oder Fahrzeuglogo (oder auch Herstellerlogo) hinterleuchtet und dem Benutzer eine klar lokalisierbare und einfach zu betätigende Einrichtung bietet. Der Benutzer kann sowohl eine Druckbetätigung ausführen als auch eine Annäherungsbetätigung, registriert durch den Annäherungssensor 9b. Die Steuer- und Auswerteeinrichtung 9a steuert die Lichtquelle 9c in Abhängigkeit von den Betätigungen an. Die Lichtquelle 9c kann also in Abhängigkeit von der mechanischen Betätigung angesteuert werden, die durch den Druckschalter 9a sensiert wird, und auch durch die Annäherungserkennung durch Sensor 9b. Außerdem kann die Steuer- und Auswerteschaltung 9d über die Lichtquelle 9c ein Feedback an den Benutzer geben, um ihm zum Einhalten eines bestimmten Benutzungsschemas anzuleiten. So kann der Benutzer beispielsweise angehalten sein, eine Betätigung in Gestalt einer Annäherung oder Entfernung eines Körperteils innerhalb einer Zeitspanne vorzunehmen, die durch ein Lichtsignal sichtbar gemacht wird.

Grundsätzlich können auch noch weitere Komponenten in die Betätigungseinrichtung 1 aufgenommen werden. Wesentlich ist jedoch, dass eine Deckeinrichtung mit einem teilweise metallisierten Emblem vorgesehen ist und die Deckeinrichtung mit einer Lichtverteileinrichtung hinterleuchtbar ist, wo die Beleuchtung durch eine Steuer- und Auswertevorrichtung angesteuert wird. Die Kombination mit einem Annäherungssensor bietet dann die oben genannten Vorteile einer integrierten Betätigungseinrichtung mit einer benutzerfreundlichen Betätigungsmöglichkeit.

## Patentansprüche

1. Betätigungseinrichtung (1) zur Betätigung einer Fahrzeugfunktion, mit
einem Deckelement (2), wobei das Deckelement (2) einen nach außen gerichteten, wenigstens teilweise aus elektrisch leitfähigem metallischen Material ausgebildeten Bedienbereich (5) aufweist, wobei der Bedienbereich galvanisch von den Übrigen Komponenten entkoppelt ist,
wobei unter dem Deckelement (2) eine Lichtverteileinrichtung (7) mit einer unter oder in der Lichtverteileinrichtung angeordneten Lichtquelle (9c) angeordnet ist, wobei die Lichtquelle (9c) und die Lichtverteileinrichtung (7) zur Hinterleuchtung des Deckelementes (2) angeordnet sind,
wobei die Lichtverteileinrichtung (7) aus einem elektrisch isolierenden transparenten Kunststoff ausgebildet ist und das Deckelement (2) von den übrigen Elementen galvanisch entkoppelt,
wobei unter der Lichtverteileinrichtung (7) eine Platine (8) mit einem kapazitiven Sensor (9b) derart angeordnet ist, dass der kapazitive Sensor mit dem Bedienbereich (5) kapazitiv gekoppelt ist,
wobei eine Steuer- und Auswerteschaltung (9d) mit der Lichtquelle (9c) und dem kapazitiven Sensor (9b) gekoppelt ist, um die Lichtquelle in Abhängigkeit von einer Annäherung zu schalten,
**dadurch gekennzeichnet,**
**dass** unterhalb des Deckelements (2), auf der Platine (8) ein Schalter (9a) angeordnet ist und das Deckelement (2) gegenüber dem Schalter bewegbar angeordnet ist, so dass durch mechanische Einwirkung auf das Deckelement (2) eine Schalterbetätigung erfolgt.

2. Betätigungseinrichtung nach Anspruch 1, wobei das Deckelement eine teilweise lichtundurchlässige Frontseite aufweist und wobei die Lichtverteileinrichtung zum Ausleuchten der lichtdurchlässigen Bereiche des Deckelementes ausgebildet ist.

3. Betätigungseinrichtung nach einem der vorangehenden Ansprüche, wobei die Lichtverteileinrichtung Lichtleitbereiche zum Leiten und Lenken von Licht aus der Lichtquelle aufweist.

4. Betätigungseinrichtung nach einem der vorangehenden Ansprüche, wobei die Lichtverteileinrichtung Diffusorbereiche zum Streuen von Licht aus der Lichtquelle aufweist.

## Claims

1. Actuating device (1) for actuating a vehicle function, having
a cover element (2), the cover element (2) having an operating region (5) which is directed outwards and is formed at least partially from electrically conductive metallic material, the operating region being electrically decoupled from the remaining components,
wherein a light distributing device (7) with a light source (9c) arranged below or in the light distributing device is arranged below the cover element (2), wherein the light source (9c) and the light distributing device (7) are arranged for backlighting the cover element (2),
wherein the light distributing device (7) is made of an electrically insulating transparent plastic and galvanically decouples the cover element (2) from the other elements,
wherein a circuit board (8) with a capacitive sensor (9b) is arranged under the light distributing device (7) in such a way that the capacitive sensor is capacitively coupled to the operating region (5),
wherein a control and evaluation circuit (9d) is coupled to the light source (9c) and the capacitive sensor (9b) to switch the light source in response to an approach,
**characterized in**
**in that** a switch (9a) is arranged below the cover element (2), on the circuit board (8), and the cover element (2) is arranged movably with respect to the switch, so that switch actuation takes place by mechanical action on the cover element (2).

2. Actuating device according to claim 1, wherein the cover element has a partially opaque front side and wherein the light distributing device is designed to illuminate the light-transmitting regions of the cover element.

3. Actuating device according to any one of the preceding claims, wherein the light distributing device comprises light guiding portions for guiding and directing light from the light source.

4. Actuating device according to any one of the preceding claims, wherein the light distributing device comprises diffusing portions for diffusing light from the light source.

## Revendications

1. Dispositif d'actionnement (1) pour actionner une fonction du véhicule, comprenant
un élément de couvercle (2), l'élément de couvercle (2) présentant une zone de commande (5) orientée vers l'extérieur et réalisée au moins partiellement en un matériau métallique électriquement conducteur, la zone de commande étant découplée galvaniquement des autres composants,
un dispositif de répartition de lumière (7) avec une source de lumière (9c) disposée sous ou dans le dispositif de répartition de lumière étant disposé sous l'élément de couvercle (2), la source de lumière (9c) et le dispositif de répartition de lumière (7) étant disposés pour le rétroéclairage de l'élément de couvercle (2),
dans lequel le dispositif de répartition de la lumière (7) est réalisé en une matière plastique transparente électriquement isolante et il découple galvaniquement l'élément de couvercle (2) des autres éléments,
une platine (8) avec un capteur capacitif (9b) étant disposée sous le dispositif de répartition de lumière (7) de telle sorte que le capteur capacitif est couplé de manière capacitive avec la zone de commande (5),
un circuit de commande et d'évaluation (9d) étant couplé à la source lumineuse (9c) et au capteur capacitif (9b) afin de commuter la source lumineuse en fonction d'une approche,
**caractérisé**
**en ce qu'**un interrupteur (9a) est disposé sur la platine (8) en dessous de l'élément de couvercle (2) et que l'élément de couvercle (2) est disposé de manière mobile par rapport à l'interrupteur, de sorte qu'un actionnement de l'interrupteur est effectué par une action mécanique sur l'élément de couvercle (2).

2. Dispositif d'actionnement selon la revendication 1, dans lequel l'élément de couvercle présente une face frontale partiellement opaque et dans lequel le dispositif de répartition de la lumière est conçu pour éclairer les zones transparentes de l'élément de couvercle.

3. Dispositif d'actionnement selon l'une quelconque des revendications précédentes, dans lequel le dispositif de répartition de la lumière comprend des zones de guidage de la lumière pour guider et diriger la lumière provenant de la source de lumière.

4. Dispositif d'actionnement selon l'une quelconque des revendications précédentes, dans lequel le dispositif de répartition de la lumière comprend des zones de diffusion pour diffuser la lumière provenant de la source lumineuse.
